# EUROPEAN PATENT APPLICATION

(11) **EP 3 809 517 A1**
(43) Date of publication of application: **21.04.2021**
(21) Application number: 19203959.2
(22) Date of filing: 17.10.2019
(51) Int. Cl.: H01P 1/02, H01P 1/18, H01P 3/02, H01P 3/08, H05K 1/02

(54) **TRANSMISSION LINE FOR RADIO FREQUENCY SIGNALS**

(71) Applicant: ALCAN Systems GmbH, 64293 Darmstadt (DE)
(72) Inventor: Gäbler, Alexander, 64287 Darmstadt (DE)
(74) Representative: Habermann Intellectual Property Partnerschaft von Patentanwälten mbB

(57) **Abstract**

A transmission line (1) for transmitting a radio frequency signal with a first electrode (9) and a second electrode (10). The radio frequency signal is transmitted along the first electrode (9) and the second electrode (10). The first electrode (9) and the second electrode (10) are for most of a length of the transmission line (1) spaced apart at a distance along a first transverse (11) direction from each other. The first transverse direction (11) is perpendicular to a propagation direction (3, 5) of the radio frequency signal. The transmission line (1) comprises loading capacitors (15) arranged in between the two electrodes (9, 10). The transmission line (1) comprises a bent section (6) in which the radio frequency signal is propagated from a first end (7) to a second end (8) of the bent section (6) and in which the propagation direction (3, 5) of the radio frequency signal is changed from a first propagation direction (3) at the first end (7) to a second propagation direction (5) at the second end (8). The transmission line (1) comprises a compensation section (12) for adjusting a phase difference of the radio frequency signal in the bent section (6). In the compensation section (12) a first section (13) of the first electrode (9) overlaps a first section (14) of the second electrode (10) in the first transverse direction (11), thereby forming a a loading capacitor (15).

## Description

### Technical Field

The invention relates to a transmission line for transmitting a radio frequency signal with a first electrode and a second electrode electrically isolated from each other, wherein the radio frequency signal is transmitted along the first electrode and the second electrode, wherein the first electrode and the second electrode are for most of a length of the transmission line spaced apart at a distance along a first transverse direction from each other, with the first transverse direction being perpendicular to a propagation direction of the radio frequency signal, wherein the transmission line is configured to transmit the radio frequency signal in differential mode and comprises loading capacitors arranged in between the two electrodes which affect a phase shift of the radio frequency signal transmitted along the two electrodes, wherein the transmission line comprises a bent section in which the radio frequency signal is propagated from a first end to a second end of the bent section, in which the propagation direction of the radio frequency signal is changed from a first propagation direction at the first end to a second propagation direction at the second end, and wherein the transmission line comprises a compensation section for adjusting a phase difference of the radio frequency signal so that a phase difference between the radio frequency signal running along the first electrode and running along the second electrode at the second end of the bent section is substantially unchanged with respect to a phase difference at the first end.

### Background of the invention

In many applications planar transmission lines are used to propagate a radio frequency signal between an emitter and a receiver. In planar transmission lines the radio frequency signal is propagated along at least two essentially flat conductors, in the following referred to as electrodes. Within this application radio frequency comprises a range of frequencies from 30 MHz to 300 GHz.

For some applications, e.g. a phase shifting device, a given length or a minimum length of such a transmission line is required. Thus, a space saving integration of the transmission line with for instance only a small rectangular or quadratic footprint requires an at least sectionwise bent or curved arrangement of the transmission line. In case of an arrangement of two electrodes side by side for a transmission line bent or curved in a plane comprising and defined by the arrangement of the two electrodes, a length of an inner curve electrode is shorter as compared to a length of an outer curve electrode. The resulting length difference between the two electrodes can modify a phase difference between the radio frequency signal propagated along the first electrode and the second electrode, thereby altering the radio frequency signal.

There are known prior art planar transmission lines where e.g. before or after a bent section of the transmission line an inner curve electrode is formed in such a way as to compensate for the length difference between an inner curve electrode and an outer curve electrode. For instance, there are planar transmission lines comprising a compensation section with a jagged course of the inner electrode. Moreover, there are planar transmission lines comprising a compensation section with an inner electrode with a reduced cross section as compared to a cross section of an outer electrode. Furthermore, there are planar transmission lines with an inner curve electrode comprising an open loop to delay the signal propagation along this inner curve electrode. However, the restrictions for the arrangement and the course of the electrodes within compensation section usually result in additional space requirements and imposes limitations for using this part of the transmission line for further purposes of the transmission line.

There are also known prior art planar transmission lines which are capacitively loaded with loading capacitors arranged in between the two electrodes. The loading capacitors affect a phase shift of the radio frequency signal transmitted along the transmission line.

Accordingly, there is a need for a transmission line described as above, which allows for further miniaturization of the footprint of the transmission line, particularly of a capacitively loaded transmission line.

### Summary of the invention

The present invention relates to a transmission line as described above, wherein the compensation section is arranged within the bent section, whereby in the compensation section in a first overlapping area a first section of the first electrode overlaps a first section of the second electrode in the first transverse direction, with the first section of the first electrode and the first section of the second electrode being spaced apart at a distance along a second transverse direction being perpendicular to the propagation direction and being perpendicular to the first transverse direction, so that the first section of the first electrode and the first section of the second electrode form one of the loading capacitors. By suitably arranging the two electrodes with the first section of the first electrode overlapping the first section of the second electrode in the first transverse direction within the compensation section the phase difference at the first end and at the second end of the bent section can be compensated concurrently with forming a loading capacitor within the bent section. In such a way manufacturing of a bent capacitively loaded transmission line compensated for the phase difference and comprising a loading capacitor within the bent section is facilitated. An effective electrical length of the transmission line can be shortened by the loading capacitors. Hence, by arranging the loading capacitor in the bent section the footprint of the transmission line can be reduced. The phase of the radio frequency signal running along the first electrode and the second electrode is affected equivalently by the loading capacitors, resulting in a constant phase difference between both electrodes.

The first electrode and the second electrode are preferably arranged side by side along the first transverse direction for most of the length of the transmission line. For instance, with the first electrode arranged at the inner side of the bent section with respect to the second electrode in the compensation section the first electrode can be sectionwise run towards the second electrode to form the first overlapping area, coincidently increasing the length of the first electrode and thereby compensating for a change of the phase difference at the first end and at the second end of the bent section.

The transmission line preferably comprises the bent section and two straight sections adjacent to the respective end of the bend section, with the radio frequency signal being propagated along the respective straight section in a straight line. The two electrodes can be fabricated on one common layer with only the first section of the first electrode and the first section of the second electrode separated along the second transverse direction by an insulating or dielectric material.

According to an advantageous aspect of the invention in the compensation section the first electrode traverses the second electrode in the first overlapping area. In case of the first electrode traversing the second electrode in the compensation section the first electrode runs towards the second electrode from a first side of the second electrode to the first overlapping area and continuous to run from a second side of the second electrode. For instance, for the two electrodes arranged along the first traverse direction side by side, within the bent section the two electrodes can each run along a 90° bend with the 90° bend of each of the electrodes being staggered along the transmission line, where before the respective 90° bend one of the electrodes is arranged on the inner curve side and after the bend on the outer curve side with the other electrode being arranged oppositely.

According to an advantageous embodiment of the invention, in the compensation section in a second overlapping area a second section of the first electrode traverses a second section of the second electrode, thereby forming another one of the loading capacitors, with the second overlapping area being spaced apart at a distance along the transmission line from the first overlapping area. For instance, in the compensation section the first electrode can exhibit a u-shaped or v-shaped projection along the first transverse direction, with the u-shaped or v-shaped projection twice traversing the second electrode.

According to yet another preferential embodiment of the invention, the compensation section the first electrode forms an open loop, with the open loop of the first electrode sectionwise overlapping, preferably traversing twice, the second electrode.

According to an advantageous aspect of the invention, in the compensation section a cross sectional area of the first electrode and/or of the second electrode changes along the transmission line. The phase difference between the radio frequency running along the first electrode and the second electrode is dependent on the length difference between the first electrode and the second electrode.

Furthermore, by changing the cross section of one of the electrodes with respect to the other the phase difference between the two electrodes can be modified.

To allow for a technologically easy to implement change in cross sectional area of one or both of the electrodes, according to an advantageous embodiment of the invention, in the compensation section a width of the first electrode and/or a width of the second electrode changes along the transmission line. It is possible that the loading capacitors arranged along the transmission line exhibit varying capacitances. The capacitance of the loading capacitors within the compensation section depends on the area of the first overlapping area and if applicable, of the second overlapping area. Hence, by varying the width of the first electrode and/or the second electrode within the compensation section the capacitance of the loading capacitors can be modified.
According to an advantageous embodiment of the invention, the transmission line comprises the straight sections where the radio frequency signal is propagated along a straight line, wherein the straight sections comprise several loading sections arranged and spaced apart along the transmission line, wherein in each of the loading sections the transmission line comprises first electrode protrusions electrically connected to the first electrode and second electrode protrusions electrically connected to the second electrode, with the respective first electrode protrusions and the respective second electrode protrusions at least sectionwise overlapping, wherein the overlapping protrusions are spaced apart at a distance along the second transverse direction, thereby forming the loading capacitors in the two straight sections.

According to an advantageous aspect of the invention, the first electrode is arranged on a first level and the second electrode is arranged on a second level, wherein the first level and the second level are spaced apart at a distance along the second transverse direction. For instance, the first electrode can be arranged on a front side of a substrate with the second electrode arranged on a back side of the substrate, with the back side being opposed to the front side. In such a way the two electrodes are spaced apart along the second transverse direction by a thickness of the substrate. Preferentially the first electrode is arranged on a front side of a first substrate and the second electrode is arranged on a front side of a second substrate, with the two substrates facing each other with their front sides. The two substrates can be spaced apart along the second transverse direction by a solid insulating or a dialectical material arranged at least sectionwise between the two substrates. It is also possible, that the two substrates are spaced apart along the second transverse direction by spacers.

According to an advantageous aspect of the invention, an arrangement and design of the first electrode and the second electrode is suitable and used to transmit the radio frequency signal in a differential mode with a 180° phase shift between the first electrode and the second electrode. The transmission line can for instance be designed with two balanced electrodes. Thus, the transmission line is suitable for propagating a radio frequency signal in differential mode.

According to an advantageous aspect of the invention, the arrangement and design of the first electrode and the second electrode is realised as to suppress a common mode of the radio frequency signal propagating along the transmission line by more than -20 dB, preferably by more than -30 dB. The radio frequency signal transmitted along the transmission line in a differential mode with a 180° phase shift between the first electrode and the second electrode can be altered by the common mode with a 0°phase shift between the first electrode and the second electrode.

According to an advantageous embodiment of the invention, the transmission line comprises a tunable dielectric material, wherein the tunable dielectric material is arranged at least sectionwise between the first electrode protrusions and the second electrode protrusions within the loading capacitors so that the tunable dielectric material affects a phase shift of the radio frequency signal propagating along the transmission line. In phased array antennas comprising several antenna elements arranged next to each on an antenna plane a predetermined phase difference between the respective antenna elements can be used to change a signal direction of a signal emitted or received by the phased array antenna. The phase difference is predetermined in such a way as to reinforce a superposition of the signal emitted or received by the respective antenna elements along the signal direction. The predetermined phase difference at the respective antenna element can be provided by using a dedicated phase shifting device providing for an adjustable phase shift connected to each of the antenna elements of the phased array antenna. Phase shifting devices commonly use a transmission line with a variable electrical length to provide for the adjustable phase shift.

Arranging the tunable dielectric material within the loading capacitors of the transmission line allows for adjusting the phase shift of a signal propagating along the transmission line by tuning the dielectric characteristics of the tunable dielectric material. Preferably the tunable dielectric material is a liquid crystal material with a high dependency of the dielectric characteristics on an electric field that is applied to the liquid crystal material. Suitable liquid crystal materials as well as other tunable dielectric materials are known in the art and commercially available. The electric field that is applied to the liquid crystal material superimposes the radio frequency signal that is propagated along the transmission line, but this does not significantly interfere with the signal propagation.

According to an advantageous embodiment of the invention, the tunable dielectric material is arranged at least sectionwise between the first electrode and the second electrode in the overlapping areas in the compensation section. The first section of the first electrode and the first section of the second electrode form a first compensating section capacitor and, if applicable, the second section of the first electrode and the second section of the second electrode form a second compensating section capacitor. The tunable material can be arranged within the first and the second compensating section capacitor. In such a way the straight sections and the bent section of the transmission line can provide for a phase shift. Thus, for a comparable phase shift the length of the transmission line comprising the compensation section capacitor can be reduced.

According to an advantageous embodiment of the invention, the the first and/or the second electrode is electrically connected to a bias voltage source. The bias voltage can be a constant bias voltage or a preferably low frequency voltage with a frequency of up to several kHz. The bias voltage does not interfere with the signal propagation along the transmission line of the phase shifting device. The bias voltage that is applied to the first and second electrode by the bias voltage affects the dielectric characteristics of the tunable dielectric material that is arranged between the first and the second electrode. By applying a bias voltage to the first and second electrode and thereby affecting and changing the dielectric properties of the tunable dielectric material in between the loading capacitors and/or the compensation sector capacitors the phase difference between the input signal and the output signal of the phase shifting device can be easily and reliably controlled and modified according to the respective requirements.

According to an advantageous embodiment of the invention, the first electrode is connected to a first bias electrode which is connected to the bias voltage source, and that the second electrode is connected to a second bias electrode which is connected to the bias voltage source. The width of the bias electrode can be small when compared to the width of the first electrode and of the second electrode. The width can be approx. 10 % or less of the width of the first or second electrode. A small width or cross-section area of the first and second bias electrodes contributes to a high impedance of the first and second bias electrode resulting in reduced leakage of the electromagnetic signal from the first and second electrode into the first or second bias electrode. In yet another embodiment of the invention the first and second bias electrodes consists of a material with a lower electrical conductivity that the first and second electrode. The resulting higher resistance of the bias electrodes prevents the electromagnetic signal that propagates along the transmission line from leaking from the first and second electrode into the first or second bias electrode. Preferably the first and second electrode are made of or comprise a material with a high conductivity of more than 40 ^{∗} 10⁶ S/m like e.g. gold or copper. The first and second bias electrodes preferably has a sheet resistance of more than 20 Ohms/square and can be made of or comprise Indium Tin Oxide (ITO) or Nichrome (NiCr).

### Brief description of the drawings

The present invention will be more fully understood, and further features will become apparent, when reference is made to the following detailed description and the accompanying drawings. The drawings are merely representative and are not intended to limit the scope of the claims. In fact, those of ordinary skill in the art may appreciate upon reading the following specification and viewing the present drawings that various modifications and variations can be made thereto without deviating from the innovative concepts of the invention. Like parts depicted in the drawings are referred to by the same reference numerals.
Figure 1 illustrates a schematic top view of a transmission line,
Figure 2 illustrates a sectional view of the transmission line as shown in figure 1 taken along the line II-II,
Figure 3 illustrates a sectional view of the transmission line as shown in figure 1 taken along the line III-III,
Figure 4 illustrates a sectional view of the transmission line as shown in figure 1 taken along the line IV-IV,
Figures 5, 6 and 7 each illustrate a schematic top view of an alternative embodiment of the transmission line,
Figure 8 illustrates a dampening of a common mode of the transmission line as shown in figure 5, and
Figure 9 illustrates the dampening of the common mode of the transmission line as shown in figure 6.

### Detailed description of the invention

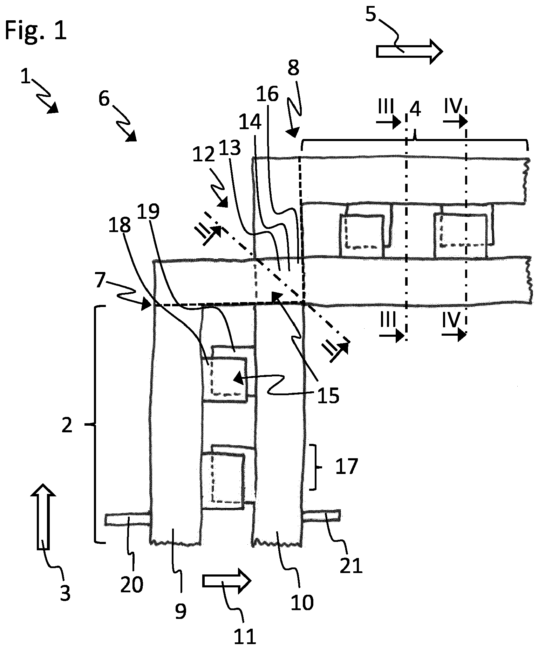

Figure 1 illustrates a schematic top view of an embodiment of the transmission line 1. The transmission line comprises a first straight section 2 in which a radio frequency signal is propagated along a first propagation direction 3 and a second straight section 4 in which the radio frequency signal is propagated along a second propagation direction 5. The transmission line 1 further comprises a bent section 6 in which the propagation direction 3, 5 is changed from the first propagation direction 3 to the second propagation direction 5 when the radio frequency signal propagates from a first end 7 of the bent section 6 to a second end 8 of the bent section 6.

The transmission line 1 comprises a first electrode 9 and a second electrode 10, which are arranged side by side and spaced apart at a distance along a first transverse direction 11 from each other in the straight sections 2, 4. The bent section 6 comprises a compensation section 12 for adjusting a phase difference of the radio frequency signal running along the first electrode 9 and the second electrode 10. In the embodiment of the transmission line 1 shown in figure 1 in the bent section 6 the first electrode 9 and the second electrode 10 comprise each a 90° bend with the respective 90° bends being staggered so that the first electrode 9 traverses the second electrode 10 within the compensation section 12. Hereby a first section 13 of the first electrode 9 overlaps a first section 14 of the second electrode 10, forming a loading capacitor 15 in a first overlapping area 16.

In the straight sections 2, 4 the transmission line 1 comprises loading sections 17 with neighboring loading sections 17 being spaced apart along the transmission line 1. In each of the loading sections 17 the transmission line 1 comprises first electrode protrusions 18 and second electrode protrusions 19, with the first electron protrusions 18 protruding from the first electrode 9 towards the second electrode 10 and with the second electrode protrusions 19 protruding from the second electrode 10 towards the first electrode 9, and with the respective first electrode protrusions 18 overlapping the respective second electrode protrusions 19 forming the loading capacitors 15. In the embodiment of the transmission line 1 illustrated in figure 1 a capacitance of the respective loading capacitors 15 varies along the transmission line 1. The first electrode 9 is connected to a first bias electrode 20 while the second electrode 10 is connected to a second bias electrode 21.

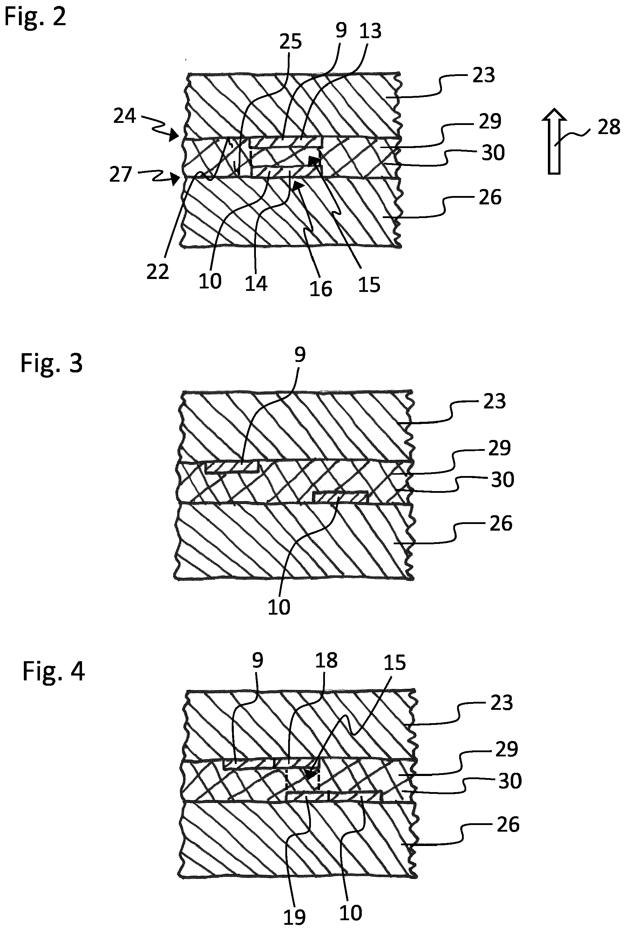

Figures 2, 3 and 4 illustrate three sectional views of the transmission line 1 as shown in figure 1. Figure 2 is a sectional view of the first overlapping area 16 in the compensation section 12. Figure 3 is a sectional view of a section of the second straight section 4 spacing apart two loading sections 17. Figure 4 is a is a sectional view of one of the loading sections 17.

The first electrode 9 is arranged on a front surface 22 of a first substrate 23 forming a first level 24. The second electrode 10 is arranged on a front surface 25 of a second substrate 26 forming a second level 27. The two substrates 23, 26 can be manufactured from glass. The two substrates 23, 26 are spaced apart along a second transverse direction 28. In between the two substrates 23, 26 a tunable dielectric material 29 is arranged, which in this embodiment is a liquid crystal material 30. The first section 13 of the first electrode 9 and the first section 14 of the second electrode 10 form a first overlapping area 16.

In the loading section 17 an overlapping section of the first electrode protrusion 18 and the second electrode protrusion 19 form the loading capacitor 15. A capacitance of the loading capacitors 15 of the loading sections 17 affects a phase shift of the transmission line 1. The loading capacitor 15 is filled with the liquid crystal material 30. By applying an electric field to the first electrode 9 and the second electrode 10 via the first bias electrode 20 and the second bias electrode 21 dielectric characteristics of the liquid crystal material 30 can be changed thereby modifying a phase shift of the transmission line 1. In such a way the transmission line 1 can be used as a phase shifting device.

In the compensation section 12 within the bent section 6 of the transmission line 1 the loading capacitor 15 is formed between the first section 13 of the first electrode 9 and the first section 14 of the second electrode 10. The loading capacitor 15 in the compensating section 12 is also filled with the liquid crystal material 30, so that by applying the electrical field to the first electrode 9 and the second electrode 10 the loading capacitor 15 in the compensating section 12 affects the phase shift of the transmission line 1. With providing for the loading capacitor 15 in the compensating section 12 within the bent section 6 a length of the transmission line 1 can be reduced with respect to a bent transmission line not featuring a capacitor in a bent section.

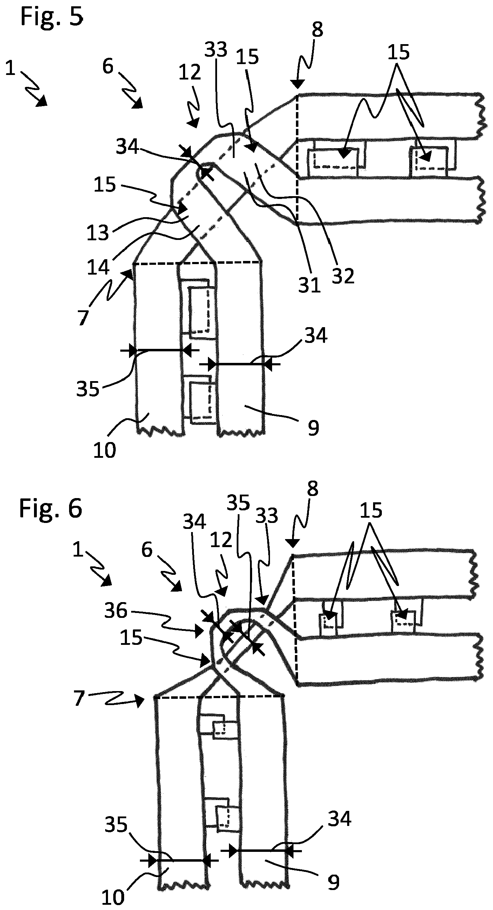

Figure 5 illustrates an alternative embodiment of the transmission line 1. In the compensation section 12 the first electrode 9 comprises a u-shaped projection traversing the second electrode 10 twice. Thus, the first sections 13, 14 form the first overlapping area 16 and a second section 31 of the first electrode 9 and a second section 32 of the second electrode 10 form a second overlapping area 33. A width 34 of the first electrode 9 is reduced in the compensation section 12 while a width 35 of the second electrode 10 remains constant along the transmission line 1.

Figure 6 illustrates yet another alternative embodiment of the transmission line 1. Here the first electrode 9 comprises an open loop 36 twice traversing the second electrode 10. The widths 34, 35 of both electrodes 9, 10 are reduced within the compensation section 12.

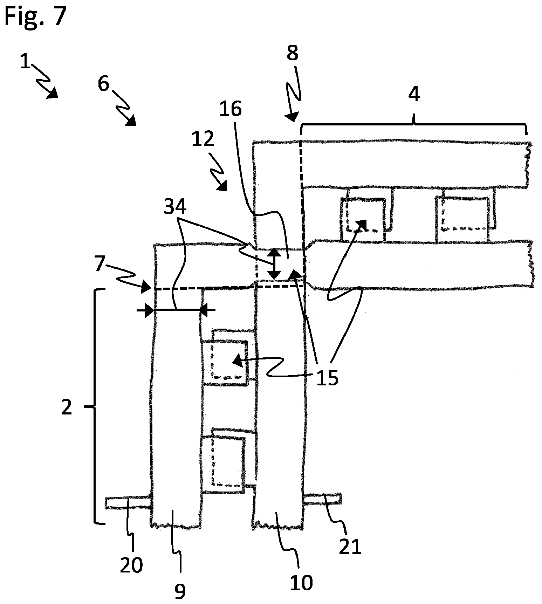

Figure 7 illustrates a top view another alternative embodiment of the transmission line 1. The embodiment shown in figure 7 resembles the embodiment of the transmission line 1 shown in figure 1. In the embodiment shown in figure 7 the width 34 of the first electrode 9 in reduced in the first overlapping area 16 as to reduce a capacitance of the loading capacitor 15 formed in the compensation section 12.

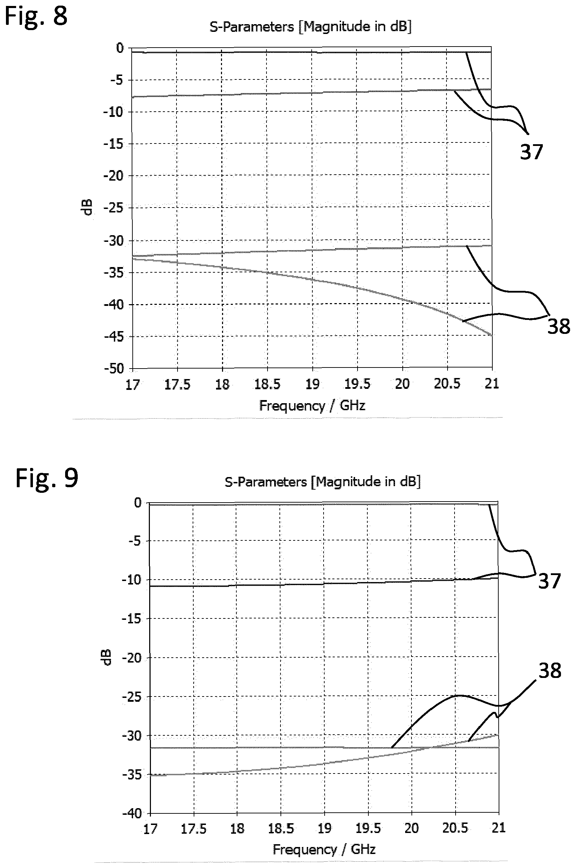

The embodiments of the transmission line 1 shown in figures 1, 5, 6, and 7 are suitable and used to transmit the radio frequency signal in a differential mode 37 with a 180° phase shift between the first electrode 9 and the second electrode 10 along the transmission line 1. When transmitting the radio frequency signal in the differential mode 37 the occurrence of a common mode 38 with a 0° degree phase shift can compromise the radio frequency signal transmitted. The embodiments of the transmission line 1 depicted in figures 5 and 6 are designed to suppress the common mode 38 by at least -30 dB. This can be deduced from simulated S-parameters for the two embodiments illustrated in figures 5 and 6. Figure 8 illustrates the simulated S-parameters for the embodiment depicted in figure 5 and figure 9 illustrates the simulated S-parameters for the embodiment depicted in figure 6.

## Claims

1. Transmission line (1) for transmitting a radio frequency signal with a first electrode (9) and a second electrode (10) electrically isolated from each other, wherein the radio frequency signal is transmitted along the first electrode (9) and the second electrode (10), wherein the first electrode (9) and the second electrode (10) are for most of a length of the transmission line (1) spaced apart at a distance along a first transverse direction (11) from each other, with the first transverse direction (11) being perpendicular to a propagation direction (3, 5) of the radio frequency signal, wherein the transmission line (1) is configured to transmit the radio frequency signal in differential mode and comprises loading capacitors (15) arranged in between the two electrodes (9, 10) which affect a phase shift of the radio frequency signal transmitted along the two electrodes (9, 10), wherein the transmission line (1) comprises a bent section (6) in which the radio frequency signal is propagated from a first end (7) to a second end (8) of the bent section (6), in which the propagation direction (3, 5) of the radio frequency signal is changed from a first propagation direction (3) at the first end (7) to a second propagation direction (5) at the second end (8), and wherein the transmission line (1) comprises a compensation section (12) for adjusting a phase difference of the radio frequency signal so that a phase difference between the radio frequency signal running along the first electrode (9) and the second electrode (10) at the second end (8) of the bent section (6) is substantially unchanged with respect to a phase difference at the first end (7), **characterised in that** the compensation section (12) is arranged within the bent section (6), whereby in the compensation section (12) in a first overlapping area (16) a first section (13) of the first electrode (9) overlaps a first section (14) of the second electrode (10) in the first transverse direction (11), with the first section (13) of the first electrode (9) and the first section (14) of the second electrode (10) being spaced apart at a distance along a second transverse direction (28) being perpendicular to the propagation direction (3, 5) and being perpendicular to the first transverse direction (11), so that the first section (13) of the first electrode (9) and the first section (14) of the second electrode (10) form one of the loading capacitors (15).

2. Transmission line (1) according to claim 1, **characterised in that** in the compensation section (12) the first electrode (9) traverses the second electrode (10) in the first overlapping area (16).

3. Transmission line (1) according to claim 2, **characterised in that** in the compensation section (12) in a second overlapping area (33) a second section (31) of the first electrode (9) traverses a second section (32) of the second electrode (10), thereby forming another one of the loading capacitors (15), with the second overlapping area (33) being spaced apart at a distance along the transmission line (1) from the first overlapping area (16).

4. Transmission line (1) according to one or more of the preceding claims, **characterised in that** in the compensation section (12) the first electrode (9) forms an open loop (36), with the open loop (36) of the first electrode (9) sectionwise overlapping, preferably traversing twice, the second electrode (10).

5. Transmission line (1) according to one or more of the preceding claims, **characterised in that** in the compensation section (12) a cross sectional area of the first electrode (9) and/or of the second electrode (10) changes along the transmission line (1).

6. Transmission line (1) according to claim 5, **characterised in that** in the compensation section (12) a width (34) of the first electrode (9) and/or a width (35) of the second electrode (10) changes along the transmission line (1).

7. Transmission line (1) according to one or more of the preceding claims, **characterised in that** the transmission line (1) comprises a straight section (2, 4) where the radio frequency signal is propagated along a straight line, wherein the straight section (2, 4) comprises several loading sections (17) arranged and spaced apart along the transmission line (1), wherein in each of the loading sections (17) the transmission line (1) comprises first electrode protrusions (18) electrically connected to the first electrode (9) and second electrode protrusions (19) electrically connected to the second electrode (10), with the respective first electrode protrusions (18) and the respective second electrode protrusions (19) at least sectionwise overlapping, wherein the overlapping protrusions (18, 19) are spaced apart at a distance along the second transverse direction (28), thereby forming the loading capacitors (15) in the two straight sections (2, 4) .

8. Transmission line (1) according to one or more of the preceding claims, **characterised in that** the first electrode (9) is arranged on a first level (24) and that the second electrode (10) is arranged on a second level (27), wherein the first level (24) and the second level (27) are spaced apart at a distance along the second transverse direction (28) .

9. Transmission line (1) according to one or more of the preceding claims, **characterised in that** an arrangement and design of the first electrode (9) and the second electrode (10) is suitable and used to transmit the radio frequency signal in a differential mode (37) with a 180° phase shift between the first electrode (9) and the second electrode (10) .

10. Transmission line (1) according to claim 9, **characterised in that** the arrangement and design of the first electrode (9) and the second electrode (10) is realised as to suppress a common mode (38) of the radio frequency signal propagating along the transmission line (1) by more than -20 dB, preferably by more than -30 dB.

11. Transmission line (1) according to one or more of the claims 7 to 10, **characterised in that** the transmission line (1) comprises a tunable dielectric material (29), wherein the tunable dielectric material (29) is arranged at least sectionwise between the first electrode protrusions (18) and the second electrode protrusions (19) within the loading capacitors (15) so that the tunable dielectric material (29) affects a phase shift of the radio frequency signal propagating along the transmission line (1).

12. Transmission line (1) according to claim 11, **characterised in that** the tunable dielectric material (29) is arranged at least sectionwise between the first electrode (9) and the second electrode (10) in the overlapping areas (16, 33) in the compensation section (12) .

13. Transmission line according to one or more of the claims 11 or 12, **characterised in that** the first electrode (9) and/or the second electrode (10) is electrically connected to a bias voltage source.
